# EUROPEAN PATENT SPECIFICATION

(11) **EP 2 790 477 B1**
(45) Date of publication and mention of the grant of the patent: **13.06.2018**
(21) Application number: 13162655.8
(22) Date of filing: 08.04.2013
(51) Int. Cl.: H05K 7/12, H01G 2/02, F24C 15/00

(54) **A fixing device for a capacitor and a cooking oven including a cooling channel with the fixing device**
Befestigungsvorrichtung für einen Kondensator und ein Herd mit einem Kühlkanal mit der Besfestugungsvorrichtung
Dispositif de fixation destiné à un condensateur et un four de cuisson comprenant un canal de refroidissement avec le dispositif de fixation

(43) Date of publication of application: 15.10.2014
(73) Proprietor: Electrolux Appliances Aktiebolag, 105 45 Stockholm (SE)
(72) Inventor: Specht, Trevor, 91541 Rothenburg ob der Tauber (DE); Militzer-Keil, Marian, 07907 Schleiz (DE)
(74) Representative: Electrolux Group Patents

(56) References cited:
- US-A1- 2011 244 712

## Description

The present invention relates to a fixing device for a capacitor according to the preamble of claim 1. In particular, the fixing device is provided for a cooking oven. Further, the present invention relates to a cooking oven including a cooling channel with the fixing device.

The cooling channel in a cooking oven is usually arranged above the oven cavity. Inside said cooling channel electric and/or electronic components are arranged. For example, a capacitor is fixed in the cooling channel by a bracket. For the production line there is not given any clear position of said capacitor in the cooling channel. If the capacitor is placed in an inappropriate position, then the cables or other part do not fit. Another problem may be a small gap between a top wall of the cooking oven and the capacitor below. Further, other electronic components like a diode may be damaged. Moreover, the wrong position of the capacitor may cause noises.

US 5,999,412 discloses a printed circuit board and a method for the precise assembly of electronic components on a surface of the printed circuit board. The electronic components are conductively attached at the printed circuit board by a reflow soldering technique. The printed circuit board comprises sections for receiving the electronic components on its surface. The sections are slotted contours or grooves. Said sections are shaped to secure that the electronic components are held in their desired positions after the application of solder paste. However, the printed circuit board requires the sections for receiving the electronic components, wherein the sizes and contours of said sections must be adapted to the electronic components.

US 2011/0244712 A1 discloses an electrical appliance. The electrical appliance includes a housing having a holding chamber and an insert slot, an insulation displacement connector, and an electrical component such as a battery or capacitor inserted into the holding chamber. An electric connector of said electrical component extends through the holding chamber into the insert slot. Upon inserting the insulation displacement connector into the insert slot, the insulation displacement connector contacts the electric connector of the electrical component on the one hand and a printed circuit board mounted to the housing on the other hand, so that the electrical component and the printed circuit board are electrically connected via the electric connector of the electrical component and the insulation displacement connector. Since the holding chamber encloses substantially the whole electrical component and the insert slot requires an exact geometric structure, the housing is formed very complex.

It is an object of the present invention to provide a fixing device for a capacitor in an appliance by low complexity.

The object of the present invention is achieved by the fixing device according to claim 1.

According to the present invention the fixing device is an integrated part of a cooling channel, wherein the cooling channel is made of plastics and arranged or arrangeable in the appliance, and wherein the bedstop loop is provided for enclosing the capacitor beside the rear face side of the capacitor, and wherein the retaining loop is provided for enclosing a central portion of the capacitor, and wherein the front clip element is directly arranged at the cooling channel.

The main idea of the present invention is the fixing device as integrated part of the cooling channel, so that the capacitor is always placed in the predetermined position. The components of the fixing device, i.e. the bedstop loop, the retaining loop and the front clip element are integrated parts of the cooling channel. The bedstop loop and the retaining loop enclose the capacitor. The front clip element allows a fixation of the capacitor without any tools and by low complexity.

The bedstop loop is provided for enclosing the capacitor beside the rear face side of the capacitor.

The retaining loop is provided for enclosing a central portion of the capacitor.

Further, the bedstop loop and/or the retaining loop may be provided for enclosing a curved surface area of the capacitor.

The front clip element is directly arranged at the cooling channel.

Moreover, the bedstop loop may include a rear clip element provided for bearing against the curved surface area of the capacitor. Said rear clip element prevents vibrations of the capacitor.

According to another aspect, the retaining loop includes at least one spacer element extending in an opposite direction to the cooling channel. The spacer element ensures that a top wall or side wall has a minimum distance to the capacitor.

In particular, the capacitor is fastened or fixable by the fixing device by a partial penetrating through the retaining loop, an inserting into the bedstop loop and a snapping-in with the front clip element. The capacitor can be mounted by one movement of the hand.

Further, the cooling channel may comprise a diode retainer provided for receiving at least one diode, wherein the at least one diode and the diode retainer form a snap-in mechanism.

Also the diode retainer may be an integrated part of the cooling channel.

Preferably, the diode retainer is arranged beside the fixing device.

Furthermore, the present invention relates to a cooking oven including at least one cooling channel mentioned above.

For example, the cooling channel is arranged or arrangeable between an oven cavity and a top wall of the cooking oven.

Alternatively or additionally, the cooling channel is arranged or arrangeable between an oven cavity and a side wall of the cooking oven.

The present invention will be described in further detail with reference to the drawing, in which
- FIG 1: illustrates a partial perspective view of a capacitor arranged in a cooling channel of a cooking oven according to a preferred embodiment of the present invention, and
- FIG 2: illustrates a perspective view of the cooling channel of the cooking oven according to the preferred embodiment of the present invention.

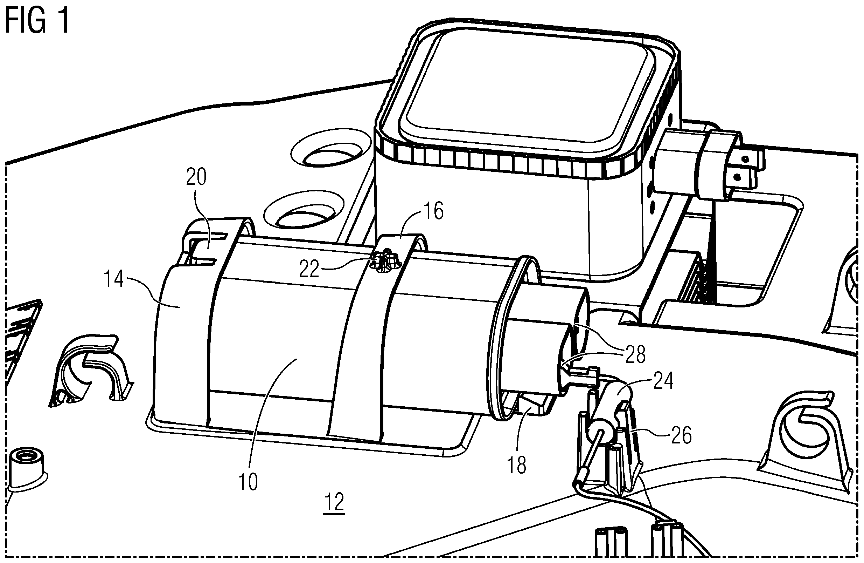

FIG 1 illustrates a partial perspective view of a capacitor 10 arranged in a cooling channel 12 of a cooking oven according to a preferred embodiment of the present invention.

The cooling channel 12 is arranged above an oven cavity of the cooking oven. The cooling channel 12 is made of plastics. The capacitor 10 is fastened in the cooling channel 12 by a fixing device. The fixing device includes a bedstop loop 14, a retaining loop 16, a front clip element 18 and a rear clip element 20. The bedstop loop 14, the retaining loop 16 and the front clip element 18 are integrated parts of the cooling channel 12. The rear clip element 20 is an integrated part of the bedstop loop 14. The rear clip element 20 is arranged in an upper part of the bedstop loop 14. The bedstop loop 14 and the retaining loop 16 enclose the capacitor 10.

The capacitor 10 comprises two terminals 28. The terminals 28 are arranged at a front face side of the capacitor 10. A rear face side of the capacitor 10 is supported by the bedstop loop 14. Further, the bedstop loop 14 encloses the capacitor 10 besides the rear face side of said capacitor 10. The retaining loop 16 encloses the capacitor 10 in a central portion of said capacitor 10. The front clip element 18 is directly arranged at the cooling channel 12. The front clip element 18 and the lower border of the front face side of the capacitor 10 form a snap-in mechanism. The rear clip element 20 at the bedstop loop 14 holds the capacitor 10. The rear clip element 20 prevents a vibration of the capacitor 10.

The capacitor 10 is mounted by penetrating through the retaining loop 16 and inserting into the bedstop loop 14 along a direction from the right hand side to the left hand side in FIG 1. The front clip element 18 prevents a removal of the capacitor 10 from the left hand side to the right hand side in FIG 1.

A spacer element 22 is arranged on the top side of the retaining loop 16. The spacer element 22 is an integrated part of the retaining loop 16 and extends upwards. The spacer element 22 prevents that a top wall of the cooking oven does get too close to or touches the capacitor 10. The spacer element 22 ensures that the top wall of the cooking oven has a minimum distance to the capacitor 10.

A diode 24 is arranged besides the capacitor 10. The diode 24 is electrically connected to the capacitor 10 via one of the terminals 28. The diode 24 is mounted at a diode retainer 26, which is also an integrated part of the cooling channel 12. The diode retainer 26 includes a clip element. Said clip element and the diode 24 form a snap-in mechanism.

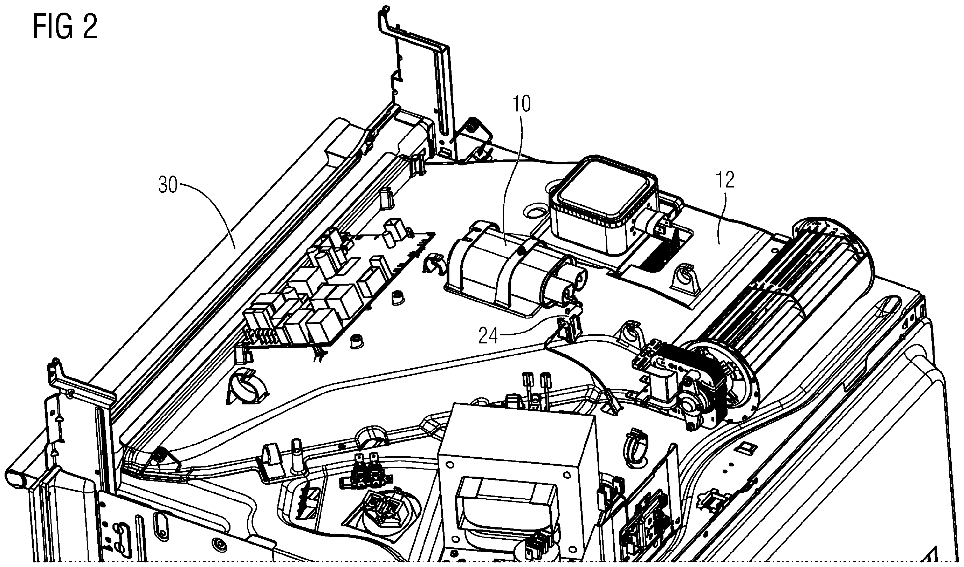

FIG 2 illustrates a perspective view of the cooling channel 12 of the cooking oven according to the preferred embodiment of the present invention. FIG 2 clarifies the positions of the cooling channel 12, the capacitor 10 and the diode 24 inside the cooking oven. The cooling channel 12 is arranged above an oven cavity and behind a front panel 30 of the cooking oven.
The fixing device according to the present invention ensures a predetermined position of the capacitor 10 in the cooling channel 12. In a similar way, the diode retainer 26 ensures a predetermined position of the diode 24. The fixing device improves the assembling of the cooling channel 12 and the cooking oven. The fixing device prevents damaging of the capacitor 10, the diode 24 and other parts. Also the diode retainer 26 prevents a damage of the diode 24 and other parts. The fixing device and/or the diode retainer 26 avoid noises.
Although an illustrative embodiment of the present invention has been described herein with reference to the accompanying drawings, it is to be understood that the present invention is not limited to that precise embodiment, and that various other changes and modifications may be affected therein by one skilled in the art without departing from the scope of the invention as defined by the appended claims.

### List of reference numerals

- 10: capacitor
- 12: cooling channel
- 14: bedstop loop
- 16: retaining loop
- 18: front clip element
- 20: rear clip element
- 22: spacer element
- 24: diode
- 26: diode retainer
- 28: terminal of the capacitor
- 30: front panel

## Claims

1. A fixing device (14, 16, 18) for a capacitor (10), said fixing device (14, 16, 18) is provided for an appliance, in particular for a cooking oven, wherein
- the fixing device includes a bedstop loop (14), a retaining loop (16) and a front clip element (18),
- the bedstop loop (14) is provided for supporting a rear face side of the capacitor (10) and for enclosing said capacitor (10),
- the retaining loop (16) is provided for enclosing the capacitor (10), and
- the front clip element (18) is provided for forming a snap-in mechanism together with a border of a front face side of the capacitor (10),
**characterized in that**
the fixing device (14, 16, 18) is an integrated part of a cooling channel (12), wherein the cooling channel (12) is made of plastics and arranged or arrangeable in the appliance, and wherein the bedstop loop (14) is provided for enclosing the capacitor (10) beside the rear face side of the capacitor (10), and wherein the retaining loop (16) is provided for enclosing a central portion of the capacitor (10), and wherein the front clip element (18) is directly arranged at the cooling channel (12).

2. The fixing device according to claim 1, **characterized in that**
the bedstop loop (14) and/or the retaining loop (16) are provided for enclosing a curved surface area of the capacitor (10) .

3. The fixing device according to any one of the preceding claims,
**characterized in that**
the bedstop loop (14) includes a rear clip element (20) provided for bearing against the curved surface area of the capacitor (10).

4. The fixing device according to any one of the preceding claims,
**characterized in that**
the retaining loop (16) includes at least one spacer element (16) extending in an opposite direction to the cooling channel (12).

5. The fixing device according to any one of the preceding claims,
**characterized in that**
the capacitor (10) is fastened or fixable by the fixing device by a partial penetrating through the retaining loop (16), an inserting into the bedstop loop (14) and a snapping-in with the front clip element (18).

6. The fixing device according to any one of the preceding claims,
**characterized in that**
the cooling channel (12) comprises a diode retainer (26) provided for receiving at least one diode (24), wherein the at least one diode (24) and the diode retainer (26) form a snap-in mechanism.

7. The fixing device according to claim 6,
**characterized in that**
the diode retainer (26) is an integrated part of the cooling channel (12).

8. The fixing device according to claim 6 or 7,
**characterized in that**
the diode retainer (26) is arranged beside the fixing device (14, 16, 18).

9. A cooking oven including at least one cooling channel (12),
**characterized in that**
the cooking oven including at least one cooling channel (12) with a fixing device (14, 16, 18) according to any one of the claims 1 to 8.

10. The cooking oven according to claim 9,
**characterized in that**
the cooling channel (12) is arranged or arrangeable between an oven cavity and a top wall of the cooking oven.

11. The cooking oven according to claim 9 or 10,
**characterized in that**
the cooling channel (12) is arranged or arrangeable between an oven cavity and a side wall of the cooking oven.

## Patentansprüche

1. Befestigungsvorrichtung (14, 16, 18) für einen Kondensator (10), wobei die Befestigungsvorrichtung (14, 16, 18) für ein Gerät, insbesondere für einen Herd, bereitgestellt ist, wobei
- die Befestigungsvorrichtung eine Anschlagsschlaufe (14), eine Halteschlaufe (16) und ein vorderes Clip-Element (18) aufweist,
- die Anschlagsschlaufe (14) zum Halten einer hinteren Stirnseite des Kondensators (10) und zum Umschließen des Kondensators (10) bereitgestellt ist,
- die Halteschlaufe (16) zum Umschließen des Kondensators (10) bereitgestellt ist, und
- das vordere Clip-Element (18) bereitgestellt ist, um gemeinsam mit einem Rand einer vorderen Stirnseite des Kondensators (10) einen Schnappmechanismus zu bilden,
**dadurch gekennzeichnet, dass**
die Befestigungsvorrichtung (14, 16, 18) ein integrierter Bestandteil eines Kühlkanals (12) ist, wobei der Kühlkanal (12) aus Kunststoff hergestellt ist und in dem Gerät angeordnet ist oder angeordnet werden kann, und wobei die Anschlagsschlaufe (14) zum Umschließen des Kondensators (10) neben der hinteren Stirnseite des Kondensators (10) bereitgestellt ist, und wobei die Halteschlaufe (16) zum Umschließen eines mittleren Abschnitts des Kondensators (10) bereitgestellt ist, und wobei das vordere Clip-Element (18) direkt an dem Kühlkanal (12) angeordnet ist.

2. Befestigungsvorrichtung nach Anspruch 1, **dadurch gekennzeichnet, dass** die Anschlagsschlaufe (14) und/oder die Halteschlaufe (16) zum Umschließen einer Mantelfläche des Kondensators (10) bereitgestellt sind.

3. Befestigungsvorrichtung nach einem der vorhergehenden Ansprüche, **dadurch gekennzeichnet, dass** die Anschlagsschlaufe (14) ein hinteres Clip-Element (20) aufweist, das bereitgestellt ist, um gegen die Mantelfläche des Kondensators (10) zu drücken.

4. Befestigungsvorrichtung nach einem der vorhergehenden Ansprüche, **dadurch gekennzeichnet, dass** die Halteschlaufe (16) mindestens ein Abstandselement (16) aufweist, das sich in einer zum Kühlkanal (12) entgegengesetzten Richtung erstreckt.

5. Befestigungsvorrichtung nach einem der vorhergehenden Ansprüche, **dadurch gekennzeichnet, dass** der Kondensator (10) durch die Befestigungsvorrichtung durch ein partielles Durchdringen der Halteschlaufe (16), ein Einführen in die Anschlagsschlaufe (14) und ein Einschnappen mit dem vorderen Clip-Element (18) befestigt ist oder befestigt werden kann.

6. Befestigungsvorrichtung nach einem der vorhergehenden Ansprüche, **dadurch gekennzeichnet, dass** der Kühlkanal (12) einen Diodenhalter (26) aufweist, der zum Aufnehmen von mindestens einer Diode (24) bereitgestellt ist, wobei die mindestens eine Diode (24) und der Diodenhalter (26) einen Schnappmechanismus bilden.

7. Befestigungsvorrichtung nach Anspruch 6, **dadurch gekennzeichnet, dass** der Diodenhalter (26) ein integrierter Bestandteil des Kühlkanals (12) ist.

8. Befestigungsvorrichtung nach Anspruch 6 oder 7, **dadurch gekennzeichnet, dass** der Diodenhalter (26) neben der Befestigungsvorrichtung (14, 16, 18) angeordnet ist.

9. Herd, der mindestens einen Kühlkanal (12) aufweist, **dadurch gekennzeichnet, dass** der Herd mindestens einen Kühlkanal (12) mit einer Befestigungsvorrichtung (14, 16, 18) nach einem der Ansprüche 1 bis 8 aufweist.

10. Herd nach Anspruch 9, **dadurch gekennzeichnet, dass** der Kühlkanal (12) zwischen einem Garraum und einer Deckwand des Herdes angeordnet ist oder angeordnet werden kann.

11. Herd nach Anspruch 9 oder 10, **dadurch gekennzeichnet, dass** der Kühlkanal (12) zwischen einem Garraum und einer Seitenwand des Herdes angeordnet ist oder angeordnet werden kann.

## Revendications

1. Dispositif de fixation (14, 16, 18) pour un condensateur (10), ledit dispositif de fixation (14, 16, 18) étant prévu pour un appareil, en particulier pour un four de cuisson, dans lequel
- le dispositif de fixation comprend une boucle d'arrêt (14), une boucle de retenue (16) et un élément d'attache avant (18),
- la boucle d'arrêt (14) est prévue pour supporter un côté de face arrière du condensateur (10) et pour entourer ledit condensateur (10),
- la boucle de retenue (16) est prévue pour entourer le condensateur (10), et
- l'élément d'attache avant (18) est prévu pour former un mécanisme d'encliquetage de concert avec une bordure d'un côté de face avant du condensateur (10),
**caractérisé en ce que** le dispositif de fixation (14, 16, 18) est une partie intégrée d'un canal de refroidissement (12), dans lequel le canal de refroidissement (12) est constitué de plastique et est agencé ou peut être agencé dans l'appareil, et dans lequel la boucle d'arrêt (14) est prévue pour entourer le condensateur (10) à côté du côté de face arrière du condensateur (10), et dans lequel la boucle de retenue (16) est prévue pour entourer une partie centrale du condensateur (10), et dans lequel l'élément d'attache avant (18) est agencé directement au niveau du canal de refroidissement (12).

2. Dispositif de fixation selon la revendication 1, **caractérisé en ce que** la boucle d'arrêt (14) et/ou la boucle de retenue (16) est (sont) prévue(s) pour entourer une région de surface courbe du condensateur (10) .

3. Dispositif de fixation selon l'une quelconque des revendications précédentes, **caractérisé en ce que** la boucle d'arrêt (14) comprend une élément d'attache arrière (20) qui est prévu pour s'appuyer contre la région de surface courbe du condensateur (10).

4. Dispositif de fixation selon l'une quelconque des revendications précédentes, **caractérisé en ce que** la boucle de retenue (16) comprend au moins un élément d'espaceur (16) qui s'étend dans une direction opposée au canal de refroidissement (12).

5. Dispositif de fixation selon l'une quelconque des revendications précédentes, **caractérisé en ce que** le condensateur (10) est attaché ou peut être attaché par le dispositif de fixation par une pénétration partielle à travers la boucle de retenue (16), une insertion dans la boucle d'arrêt (14) et un encliquetage avec l'élément d'attache avant (18).

6. Dispositif de fixation selon l'une quelconque des revendications précédentes, **caractérisé en ce que** le canal de refroidissement (12) comprend un dispositif de retenue de diode (26) qui est prévu pour recevoir au moins une diode (24), dans lequel ladite au moins une diode (24) et le dispositif de retenue de diode (26) forment un mécanisme d'encliquetage.

7. Dispositif de fixation selon la revendication 6, **caractérisé en ce que** le dispositif de retenue de diode (26) est une partie intégrée du canal de refroidissement (12).

8. Dispositif de fixation selon la revendication 6 ou 7, **caractérisé en ce que** le dispositif de retenue de diode (26) est agencé à côté du dispositif de fixation (14, 16, 18).

9. Four de cuisson comprenant au moins un canal de refroidissement (12), **caractérisé en ce que** le four de cuisson comprend au moins un canal de refroidissement (12) avec un dispositif de fixation (14, 16, 18) selon l'une quelconque des revendications 1 to 8.

10. Four de cuisson selon la revendication 9, **caractérisé en ce que** le canal de refroidissement (12) est agencé ou peut être agencé entre une cavité de four et une paroi supérieure du four de cuisson.

11. Four de cuisson selon la revendication 9 ou 10, **caractérisé en ce que** le canal de refroidissement (12) est agencé ou peut être agencé entre une cavité de four et une paroi latérale du four de cuisson.
